(19) **Europäisches Patentamt**
**European Patent Office**
**Office européen des brevets**

(11) **EP 4 589 544 A1**

(12) **EUROPEAN PATENT APPLICATION**

(43) Date of publication:
**23.07.2025  Bulletin 2025/30**

(21) Application number: **24305100.0**

(22) Date of filing: **16.01.2024**

(51) International Patent Classification (IPC):
**G06T 15/20** (2011.01)

(52) Cooperative Patent Classification (CPC):
**G06T 15/20;** G06T 2210/04; G06T 2210/12

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Dassault Systèmes**
**78140 Vélizy-Villacoublay (FR)**

(72) Inventors:
• **RAMANANA RAHARY, Adrien**
 **VELIZY VILLACOUBLAY (FR)**
• **MAILLARD, Léopold**
 **VELIZY VILLACOUBLAY (FR)**
• **DURAND, Tom**
 **VELIZY VILLACOUBLAY (FR)**

(74) Representative: **Bandpay & Greuter**
**11 rue Christophe Colomb**
**75008 Paris (FR)**

(54) **GENERATING 2D IMAGE OF 3D SCENE**

(57)  The disclosure notably relates to a computer-implemented method for machine-learning a function configured for generating a 2D image of a 3D scene (hereinafter referred to as the machine-learning method). The function comprises a scene encoder and a generative image model. The scene encoder takes as input a layout of the 3D scene and a viewpoint and outputs a scene encoding tensor. The generative image model takes as input the scene encoding tensor outputted by the scene encoder and outputs the generated 2D image. The machine-learning method comprises obtaining a dataset comprising 2D images and corresponding layouts and viewpoints of 3D scenes. The machine-learning method comprises training the function based on the obtained dataset. Such a machine-learning method forms an improved solution for generating a 2D image of a 3D scene.

FIG. 1

**Description**

**TECHNICAL FIELD**

The disclosure relates to the field of computer programs and systems, and more specifically to a method, system and program for machine-learning a function configured for generating a 2D image of a 3D scene.

**BACKGROUND**

A number of systems and programs are offered on the market for the design, the engineering and the manufacturing of objects. CAD is an acronym for Computer-Aided Design, e.g. it relates to software solutions for designing an object. CAE is an acronym for Computer-Aided Engineering, e.g. it relates to software solutions for simulating the physical behavior of a future product. CAM is an acronym for Computer-Aided Manufacturing, e.g. it relates to software solutions for defining manufacturing processes and operations. In such computer-aided design systems, the graphical user interface plays an important role as regards the efficiency of the technique. These techniques may be embedded within Product Lifecycle Management (PLM) systems. PLM refers to a business strategy that helps companies to share product data, apply common processes, and leverage corporate knowledge for the development of products from conception to the end of their life, across the concept of extended enterprise. The PLM solutions provided by Dassault Systèmes (under the trademarks CATIA, ENOVIA, 3DVIA and DELMIA) provide an Engineering Hub, which organizes product engineering knowledge, a Manufacturing Hub, which manages manufacturing engineering knowledge, and an Enterprise Hub which enables enterprise integrations and connections into both the Engineering and Manufacturing Hubs. All together the system delivers an open object model linking products, processes, resources to enable dynamic, knowledge-based product creation and decision support that drives optimized product definition, manufacturing preparation, production and service.

In this context, applications for 3D scene creation are being developed. These applications generally propose to create, manipulate and furnish 3D scenes, especially (but not exclusively) for touch-sensitive devices (e.g., smartphone or tablet). One task of these applications is the generating of realistic 2D images of the 3D scenes.

Solutions for generating 2D images for 3D scenes have been developed in recent years, e.g., using generative deep learning models. However, these solutions do not fully take into account the entire 3D environment of the scene being imaged. In particular, these solutions do not allow exploiting knowledge of the 3D structures and relationships of objects in scenes or environments. They are therefore unable to produce accurate, natural and immersive content, especially since they do not allow for perspective, occlusion or lighting factors, for example.

Within this context, there is still a need for an improved solution for generating 2D images of 3D scenes.

**SUMMARY**

It is therefore provided a computer-implemented method for machine-learning a function configured for generating a 2D image of a 3D scene (hereinafter referred to as the machine-learning method). The function comprises a scene encoder and a generative image model. The scene encoder takes input a layout of the 3D scene and a viewpoint and outputs a scene encoding tensor. The generative image model takes as input the scene encoding tensor outputted by the scene encoder and outputs the generated 2D image. The machine-learning method comprises obtaining a dataset comprising 2D images and corresponding layouts and viewpoints of 3D scenes. The machine-learning method comprises training the function based on the obtained dataset.

The machine-learning method may comprise one or more of the following:

- The layout of each 3D scene includes:

    ◦ a set of bounding boxes representing objects in the 3D scene; and
    ◦ boundaries of the 3D scene;

- The scene encoder includes a layout encoder configured for encoding the set of bounding boxes. The layout encoder takes as input, for each bounding box of the set, parameters representing a position, a size and an orientation in the 3D scene of the object represented by the bounding box, and optionally a class of the object represented by the bounding box;
- The scene encoder further includes a floor encoder configured for encoding the boundaries of the 3D scene;
- The scene encoder further includes a camera encoder configured for encoding the viewpoint;
- For each given 2D image of a given 3D scene in the dataset, the size and the position of the object represented by the bounding boxes in the layout of the given 3D scene are defined in a coordinate system that is based on a position and an orientation of a camera from which the given 2D image is taken. Each viewpoint comprises a field of view and a pitch of the camera;
- The scene encoder further includes a transformer encoder. The transformer encoder takes as input a concatenation of the set of bounding boxes encoded by the layout encoder, the viewpoint encoded by the camera encoder and the boundaries of the 3D scene encoded by the floor encoder. The transformer encoder outputs the scene encoding tensor;
- The generative image model is a diffusion model;
- The diffusion model has an architecture including a denoiser comprising blocks. At least one of the blocks is enhanced with cross-attention using the scene encoding tensor; and/or
- The diffusion model is configured for operating in a latent space. The diffusion model is trained for denoising compressed latent representations of the 2D images of the dataset.

It is also provided a method of use of a function machine-learnt according to the machine-learning method (hereinafter referred to as the using method). The using method comprises obtaining a layout of a 3D scene. The using method comprises applying the function to the layout of a 3D scene, thereby generating a 2D image of the 3D scene.
The using method may comprise one or more of the following:

- The generative image model is a diffusion model; and/or
- The applying of the function comprises:

    ◦ applying the scene encoder to the obtained layout, thereby outputting a scene encoding tensor; and
    ◦ using the diffusion model conditioned on the outputted scene encoding tensor for generating the 2D image of the 3D scene.

It is further provided a computer program comprising instructions for performing the machine-learning method and/or the using method.
It is further provided a computer readable storage medium having recorded thereon the computer program.
It is further provided a system comprising a processor coupled to a memory, the memory having recorded thereon the computer program. The system may further comprise a graphical user interface coupled to the processor.
It is further provided a device comprising a data storage medium having recorded thereon the computer program.
The device may form or serve as a non-transitory computer-readable medium, for example on a SaaS (Software as a service) or other server, or a cloud based platform, or the like. The device may alternatively comprise a processor coupled to the data storage medium. The device may thus form a computer system in whole or in part (e.g. the device is a subsystem of the overall system). The system may further comprise a graphical user interface coupled to the processor.

## BRIEF DESCRIPTION OF THE DRAWINGS

Non-limiting examples will now be described in reference to the accompanying drawings, where:

- FIG. 1 shows a flowchart of an example of the machine-learning method and of the using method;
- FIG. 2 illustrates an example of the scene encoder;
- FIG. 3 illustrates an example of camera coordinates;
- FIGs. 4 to 12 show examples of layouts and viewpoints of 3D scenes and the resulting 2D images generated by the trained function;
- FIG. 13 shows the results of a quantitative evaluation performed to evaluate the trained function; and
- FIG. 14 shows an example of the system.

## DETAILED DESCRIPTION

It is proposed a computer-implemented method for machine-learning a function configured for generating a 2D image of a 3D scene (hereinafter referred to as the machine-learning method). The function comprises a scene encoder and a generative image model. The scene encoder takes as input a layout of the 3D scene and a viewpoint and outputs a scene encoding tensor. The generative image model takes as input the scene encoding tensor outputted by the scene encoder and outputs the generated 2D image. The machine-learning method comprises obtaining a dataset comprising 2D images and corresponding layouts and viewpoints of 3D scenes. The machine-learning method comprises training the function based on the obtained dataset.
Such a machine-learning method forms an improved solution for generating a 2D image of a 3D scene.
Notably, the machine-learning method allows training the function for automatically and efficiently generating 2D images of 3D scenes. In particular, the function is trained for generating (various and realistic) 2D images from a high-level, abstract and proxy representation of the 3D scene (that is therefore easy to define). Indeed, the training enables the function to generate a 2D image of a 3D scene from a layout of the 3D scene and a viewpoint only. From these two inputs, the trained function allows generating a 2D image, which is particularly useful and interesting for illustrating objects in 3D scenes. Notably, providing these two inputs to the trained function is much easier for the user than providing a precise object model for each object in the 3D scene and then using traditional rendering methods. Hence, the trained function enables a user to easily and quickly generate 2D images of 3D scenes he or she is building, simply by defining their layout and providing viewpoints for these images.

In particular, the function is trained to generate particularly realistic and relevant 2D images of 3D scenes. Indeed, the function comprises a scene encoder that allows the layout in the generated 2D image to be taken into account. Hence, the function is able to generate 2D images that take into account the perspective of the 3D scene and its lighting, as well as occlusions between objects (the scene encoder allowing this information to be taken into account during the generation of the 2D images). In other words, the 2D image generated by the trained function is 3D-aware, i.e., it takes into account the 3D environment of the 3D scene. Notably, the method allows taking into account off-screen objects of the 3D scene when generating the 2D image, i.e., objects that are not in the sight of the camera will have an impact on the generated image (e.g., lightning from a window).

Moreover, the function is trained to generate a diversity of 2D images. Indeed, for a given 3D layout, the function is able to generate various 2D images, in terms of object style, color, etc. while still respecting the layout. It therefore allows the user to get multiple inspirations from a single input abstract layout.

Furthermore, the proposed machine learning method is trained end-to-end for the task in a single training phase. It does not rely on large pretrained image generation models, pretrained depth estimators or other external modules.

The machine-learning method and/or the using method is/are computer-implemented. This means that steps (or substantially all the steps) of the machine-learning method and/or of the using method are executed by at least one computer, or any system alike. Thus, steps of the machine-learning method and/or of the using method are performed by the computer, possibly fully automatically, or, semi-automatically. In examples, the triggering of at least some of the steps of the machine-learning method and/or of the using method may be performed through user-computer interaction. The level of user-computer interaction required may depend on the level of automatism foreseen and put in balance with the need to implement user's wishes. In examples, this level may be user-defined and/or predefined.

For examples, the using method may comprise, prior to the applying of the function to the layout of the 3D scene, a step of determining of the layout of the 3D scene, e.g., upon user interactions (e.g., carried out by a user, for example currently designing the 3D scene). The determining of the layout may comprise determining the boundaries of the 3D scene and the set of bounding boxes representing the objects in the 3D scene.

The determining of the set of bounding boxes is now discussed. The determining of the set of bounding boxes may comprise, for each bounding box of the set, a step of sizing of the bounding box and a step of positioning of the sized bounding box inside the determined boundaries of the 3D scene. The steps of sizing and positioning may be performed manually by the user. For example, the step of sizing may comprise entering by the user the width, the depth and the height (e.g., through user interaction using a keyboard). The step of positioning may comprise entering by the user coordinates of a point on the bounding box (e.g., a corner or its center) and its orientation, or may comprise moving by the user the bounding box to its location in the 3D scene (e.g., the bounding box may be displayed on a screen and may be moved by the user using a mouse). For one or more bounding boxes (e.g., all of the bounding boxes), the step of sizing may be performed semi-automatically. For example, the step of sizing may comprise selecting by the user a category of the object represented by the bounding box and suggesting automatically a size (e.g., a width, a depth and a height) of the bounding box representing the object (e.g., from a database storing default sizes for different categories of object). The suggested size may be accepted by the user or may then be refined by the user (e.g., manually as previously discussed). For example, if the user wants to add a couch to its 3D layout, the method may suggest a default bounding box that match the object category entered by the user, while letting the user modify these dimension values.

The determining of the boundaries of the 3D scene is now discussed. The determining of the boundaries of the 3D scene may comprise determining the respective set of points representing the boundaries. For example, the determining of the boundaries may comprise determining some of the points in the set (e.g. representing the corners of the 3D scene) and then sampling the other points on the boundary between these points representing the corners of the 3D scene (i.e., along the walls of the 3D scene).

The using method may also comprise, prior to the applying of the function to the layout of the 3D scene, a step of determining of the viewpoint. For example, the determining of the viewpoint may be performed by the user, e.g., by entering the coordinates and/or orientation of the viewpoint or by selecting this information on a screen displaying the 3D scene. Alternatively, the determining of the viewpoint may be performed automatically, e.g., by another function predicting one or more relevant viewpoints for a 3D scene considering its layout.

A typical example of computer-implementation of the machine-learning method and/or the using method is to perform the machine-learning method and/or the using method with a system adapted for this purpose. The system may comprise a processor coupled to a memory and a graphical user interface (GUI), the memory having recorded thereon a computer program comprising instructions for performing the machine-learning method and/or the using method. The memory may also store a database. The memory is any hardware adapted for such storage, possibly comprising several physical distinct parts (e.g. one for the program, and possibly one for the database).

The dataset considered by the machine-learning method for training the function may be stored in a database. By "database", it is meant any collection of data (i.e., information) organized for search and retrieval (e.g. a relational database, e.g. based on a predetermined structured language, e.g. SQL). When stored on a memory, the database allows a rapid search and retrieval by a computer. Databases are indeed structured to facilitate storage, retrieval, modification, and deletion of data in conjunction with various data-processing operations. The database may consist of a file or set of files that can be broken down into records, each of which consists of one or more fields. Fields are the basic units of data storage. Users may retrieve data primarily through queries. Using keywords and sorting commands, users can rapidly search, rearrange, group, and select the field in many records to retrieve or create reports on particular aggregates of data according to the rules of the database management system being used.

The method generally manipulates modeled (3D) objects. A modeled object is any object defined by data stored e.g. in the database. By extension, the expression "modeled object" designates the data itself. According to the type of the system, the modeled objects may be defined by different kinds of data. The system may indeed be any combination of a CAD system, a CAE system, a CAM system, a PDM system and/or a PLM system. In those different systems, modeled objects are defined by corresponding data. One may accordingly speak of CAD object, PLM object, PDM object, CAE object, CAM object, CAD data, PLM data, PDM data, CAM data, CAE data. However, these systems are not exclusive one of the other, as a modeled object may be defined by data corresponding to any combination of these systems. A system may thus well be both a CAD and PLM system.

By CAD system, it is additionally meant any system adapted at least for designing a modeled object on the basis of a graphical representation of the modeled object, such as CATIA. In this case, the data defining a modeled object comprises data allowing the representation of the modeled object. A CAD system may for example provide a representation of CAD modeled objects using edges or lines, in certain cases with faces or surfaces. Lines, edges, or surfaces may be represented in various manners, e.g. non-uniform rational B-splines (NURBS). Specifically, a CAD file contains specifications, from which geometry may be generated, which in turn allows for a representation to be generated. Specifications of a modeled object may be stored in a single CAD file or multiple ones.

In examples, each 3D scene may represent a real room, e.g., an indoor real room. For examples, the room represented by the 3D scene may be a room of a dwelling (e.g., a house or apartment), such as a kitchen, a bathroom, a bedroom, a living room, a garage, a laundry room, an attic, an office (e.g. individual or shared), a meeting room, a child room, a nursery, a hallway, a dining room and/or a library (this list may include other types of rooms). Alternatively, the room represented by the 3D scene may be another indoor room, such as a factory, a museum and/or a theater. Alternatively, the room represented by the 3D scene may be an outdoor scene, such as a garden, a terrace or an amusement park.

Each object of each 3D scene may represent the geometry of a real object positioned in the real room that the 3D scene represents. This real object may be manufactured in the real world subsequent to the completion of its virtual design (e.g., using a CAD software solution or a CAD system). The 3D scene may for example comprise one or more furniture objects, such as one or more chairs, one or more lamps, one or more cabinets, one or more shelves, one or more sofas, one or more tables, one or more beds, one or more sideboards, one or more nightstands, one or more desks and/or one or more wardrobes. Alternatively or additionally, the 3D scene may comprise one or more decorative objects, such as one or more accessories, one or more plants, one or more books, one or more frames, one or more kitchen accessories, one or more cushions, one or more lamps, one or more curtains, one or more vases, one or more rugs, one or more mirrors and/or one or more electronic objects (e.g., refrigerator, freezer and/or washing machine).

The using method may be included in a real-life room design (i.e., effective arrangement) process, which may comprise, after performing the using method, using the generated 2D image for illustrating a room to be arranged. For example, the illustration may be for a user such as the owner of the home in which the room is located. The generated 2D image may be used by the user for deciding whether or not to acquire one or more objects inside the 3D scene, and may assist the user's choice by showing the one or more objects in the room. During the real-life room design process, the using method may be repeated for determining several 2D images of the room. The repetition of the using method may be used to illustrate a complete virtual interior of the room (i.e., including several 2D images of the room), and/or to obtain 2D images of the 3D scene with different styles and/or object appearance.

Alternatively or additionally, the real-life room design may comprise using the generated 2D image(s) for performing a similarity-based retrieval of 3D objects from a catalog to be placed at the bounding box locations. The trained function enables this thanks to the realism of the generated 2D images. For example, the real-life room design may comprise defining by a user the layout of a given 3D scene by placing 3D bounding boxes. Then, the real-life room design may comprise generating several 2D images of the given 3D scene using the trained function (e.g., by repeating the using method as previously discussed). The real-life room design may then comprise selecting by the user one of the generated 2D images. For example, the user may particularly appreciate the look and/or style of one of the generated 2D images and want to furnish the given 3D scene with the most similar 3D objects from a catalog (i.e., replace the bounding boxes by actual 3D objects). In that case, the real-life room design may comprise, for each object of the generated 2D image, deriving the location of each object in the generated 2D image from the defined layout, cropping the object in the image, computing an image embedding of the object (e.g., using a pre-trained language-image model, such as the one described in the paper by Radford, et al. "Learning transferable visual models from natural language supervision", International conference on machine learning, PMLR 2021, hereinafter referred to as CLIP), comparing this image embedding of the object with ones from the catalog so as to get the most similar object. The real-life room design may comprise replacing the bounding boxes in the 3D scene by the most similar objects of the catalog obtained for each object.

Alternatively or additionally (e.g., prior to the illustration), the real-life room design process may comprise populating the 3D scene (which may be initially, e.g. partially, empty) representing a room with one or more new objects by modifying the layout of the 3D scene. The populating may comprise repeating, for each new object, the steps of sizing and positioning of a bounding box representing the new object as previously discussed. The generated 2D image may hence include the new objects added to the 3D scene by the modification of the layout. The real-life room design process allows creating richer, more pleasant environments (for animation, advertising and/or for generating virtual environments, e.g. for simulation). The real-life room design process may be used for generating virtual environments. The real-life room design process may be included in a general process which may comprise repeating the real-life room design process for several 3D scenes, thereby illustrating several 3D scenes with objects.

Alternatively or additionally, the real-life room design process may comprise, after the performing of the method, physically arranging a (i.e., real) room so that its design matches the 3D scene illustrated with the generated 2D image(s). For example, the room (without the object represented by the input 3D scene) may already exist in the real world, and the real-life room design process may comprise positioning, inside the already existing room (i.e., in the real world), a real object represented by one of the objects of the 3D scene (i.e., an object represented by one of the bounding boxes of the layout). The bounding box of this object may have been added to the layout of the 3D scene by the user. The real object may be positioned according to the position of its bounding box inside the 3D scene. The real-life room design process may repeat this process for positioning different real objects inside the already existing room. Alternatively, the room may not already exist at the time the method is executed. In that case, the real-life room design process may comprise building a room (i.e., including populating this room with real objects) according to the generated 2D image of the 3D scene (i.e., by placing the real objects at the position of the bounding boxes that represent them in the layout of the 3D scene). Because the method improves the positioning of the 3D objects in the 3D scene, the method also improves the building of a room corresponding to the 3D scene and thus increases productivity of the real-life room design process.

The obtaining of the dataset is now discussed.

The dataset comprises a plurality of 2D images of 3D scenes (e.g., more than 50.000 2D images, e.g., of same type of rooms). The dataset also includes, for each 2D image, the 3D scene that is imaged (e.g., partially) in the 2D image (e.g., the layout of the 3D scene only), and the viewpoint from which the 2D image is taken (e.g., the coordinates of the viewpoints inside the 3D scene). Each 2D image of the dataset may be taken for a respective (i.e., different) 3D scene. Alternatively, the dataset may comprise 2D images of same 3D scenes, e.g. taken from different viewpoints and/or with different lighting. The dataset may also comprise information indicating, for each 2D image, the layout of the 3D scene it images and its viewpoint (for example, a table comprising lines each including a 2D image reference, a reference to the layout of the corresponding 3D scene and the coordinates of the viewpoint of the 2D image).

The 2D images of the dataset may be realistic 2D images of 3D scenes produced prior to the executing of the method (e.g., by designers). These 2D images may, for example, include perspectives, occlusions and/or lighting factors. To achieve such a rendering, the 2D images of 3D scenes in the dataset may have been manually reworked by designer(s) (at least partially, for example in places where the rendering is difficult due to perspectives, occlusions and/or lighting factors).

The dataset may be stored in a database. The obtaining of the dataset may comprise retrieving the dataset from the database. Then, the obtaining of the dataset may comprise storing the retrieved dataset in memory. After the recording, the machine-learning method may perform the training of the function based on the recorded dataset. Alternatively, the obtaining of the dataset may comprise providing an access to the dataset in the database. In that case, the machine-learning method may use this access to perform the training of the function.

The rooms represented by the 3D scenes in the dataset may or could exist in the real world (already now at the time of the obtaining of the dataset or in the future). For example, the rooms may be actual real rooms (in terms of layout) of the real world, and the objects may be positioned inside these real rooms as specified in the layout of the 3D scene that the dataset comprises. The 3D scenes may represent rooms that have been designed (for example by interior designers), and then implemented in the real world (i.e., the plurality of 3D scenes corresponds to virtually designed rooms that have been, or could be, reproduced in people's homes). In examples, each room represented in the dataset is of the same type. For example, all the rooms represented in the dataset and the 3D scene may be kitchens, bathrooms, bedrooms, living rooms, garages, laundry rooms, attics, offices (e.g. individual or shared), meeting rooms, child rooms, nurseries, hallways, dining rooms or libraries (this list may include other types of rooms). In that case, the layout obtained during the executing of the using method may be a layout of a 3D scene that is also of the same type as those in the dataset. It allows generating more realistic 2D images and increases stability of the using method. Alternatively, the dataset may include rooms of different types. In that case, the output domain of the generative image model is larger, and the number of rooms represented in the dataset may be higher. The training of the generative image model may also be longer.

In examples, the layout of each 3D scene may include a set of bounding boxes representing objects in the 3D scene. Each bounding box may be rectangular in space and may encapsulate an external envelope of the object it represents. The layout may comprise, for each bounding box, parameters representing a position, a size and an orientation in the 3D scene of the object represented by the bounding box. For example, the layout may comprise, for each bounding box, parameters representing a position of the bounding box (e.g., coordinates of a corner or of the center of the bounding box), parameters representing a size of the bounding box (e.g., a width, a depth and a height of the bounding box) and parameters representing an orientation of the bounding box (e.g., a rotation with respect to each axis of a global reference frame). Optionally, the layout may comprise, for each bounding box, parameters representing a class of the object represented by the bounding box. The classes of objects may be predetermined and may each correspond to the type of object it represents. The classes of objects may be the types of decorative and functional objects discussed above.

The layout of each 3D scene may also include the boundaries of the 3D scene. For example, the boundaries of the 3D scene may be represented by a respective set of points, e.g., corresponding to the corners of the 3D scene or sampled along the walls of the 3D scene. The layout of a 3D scene may comprise the coordinates of the points of its respective set.

The training of the function may comprise training the scene encoder and the generative image model to generate the 2D images of the dataset when they take as input the corresponding layouts and viewpoints included in the dataset (e.g., in a supervised manner). For example, the scene encoder and the generative image model may each comprise respective parameters (e.g. weights), and the supervised training may consist in determining the values of these respective parameters so that they best reproduce the 2D images of the dataset when they take as input the corresponding layouts and viewpoints included in the dataset. The supervised training of the function may comprise training the scene encoder and the generative image model together (i.e., it may determine their respective parameters at the same time, or during a same process).

In examples, the scene encoder may include the layout encoder configured for encoding the set of bounding boxes. The layout encoder may take as input, for each bounding box of the set (e.g., visible or not from the viewpoint), the parameters representing the position, the size and the orientation in the 3D scene of the object represented by the bounding box. Optionally, the layout encoder may additionally take as input, for each bounding box, a parameter representing the class of the object represented by the bounding box. These parameters may be those included in the layout of the 3D scene as previously discussed. The layout encoder may deduce these parameters from the layout taken as input by the function. The layout encoder may be configured for outputting a vector (hereinafter referred to as the "layout vector") embedding the said parameters.

For example, the layout encoder may comprise a positional encoding module taking as input the parameters of the bounding boxes and outputting the layout vector. The positional encoding module may be configured for deterministically increasing the dimension of the scalar values of the parameters taken as input. For example, the positional encoding module may be configured for outputting, for each bounding box, a positional vector representing the position and size of the bounding box and an orientation vector representing the orientation of the bounding box. Optionally, the layout encoder may further comprise a first multi-layer perceptron configured for increasing the dimension of the orientation vector outputted by the positional encoding module. When the layout encoder also takes as input the class of the objects, the layout encoder may additionally comprise a second multi-layer perceptron taking as input, for each bounding box, the parameter representing the class (or category) of the object that the bounding box represents and outputting a category vector. The layout encoder may also include a concatenation layer configured for concatenating the vectors outputted by the positional encoding module, the first multi-layer perceptron layout and/or the second multi-layer perceptron layout and for outputting the said layout vector.

In examples, the scene encoder may further include the floor encoder configured for encoding the boundaries of the 3D scene. As previously discussed, the boundaries of the 3D scene may be represented by a respective set of points, and the floor encoder may take as input this respective set of points and output a floor vector. For example, the floor encoder may comprise a PointNet model (e.g., as described in the paper by Charles R. Qi, Hao Su, Kaichun Mo, and Leonidas J. Guibas., "Pointnet: Deep learning on point sets for 3d classification and segmentation", in CVPR 2017) configured for encoding the respective set of points, and optionally a multi-layer perceptron configured for taking as input the output of the PointNet model.

In examples, the scene encoder may further include the camera encoder configured for encoding the viewpoint. For example, the viewpoint may comprise parameters of a camera from which the 2D image is generated (e.g., a camera position, a field of view and a pitch). The scene encoder may be configured for taking as input these camera parameters and outputting a camera vector. For example, the scene encoder may comprise a positional encoder configured for taking as input the camera parameters, and optionally a multi-layer perceptron.

In examples, for each given 2D image of a given 3D scene in the dataset, the size and the position of the object represented by the bounding boxes in the layout of the given 3D scene are defined in a coordinate system that is based on a position and an orientation of a camera from which the given 2D image is taken. Hence, the camera position is already encoded in the layout vector outputted by the layout encoder. The viewpoint may therefore only comprise two scalar values representing respectively the field of view and the pitch of the camera. It allows reducing the number of learned parameters, increasing robustness and thus facilitating convergence of the function.

In examples, the scene encoder may further include the transformer encoder. The transformer encoder takes as input a concatenation of the set of bounding boxes encoded by the layout encoder (i.e., the layout vector), the viewpoint encoded by the camera encoder (i.e., the camera vector) and the boundaries of the 3D scene encoded by the floor encoder (i.e., the floor vector). The transformer encoder outputs the scene encoding tensor. For example, the transformer encoder may comprise a transformer model configured for taking as input a vector to form a sequence of tokens represented as a tensor (the said scene encoding tensor). The vector taken as input by the transformer model may be a concatenation of all the previously discussed vectors (i.e., the layout vector, the camera vector and the floor vector), optionally padded (or supplemented) by one or more "zero" tokens so as to constitute a vector of fixed (e.g., predetermined) size.

The generative image model may be any generative image model capable of generating a 2D image conditioned on the outputted scene encoding tensor. A generative image model may be a type of deep neural networks, which is trained on large image datasets to learn the underlying distribution of the training images. By sampling from the learned distribution, such model may be configured for producing new images that possess characteristics from the ones in the training dataset. Examples of generative image models for generating 2D images conditioned on the outputted scene encoding tensor include Generative Adversarial Networks (GANs), Variational Autoencoders (VAEs) and diffusion models.

In examples, the generative image model may be a diffusion model. The diffusion model may be configured for generating the outputted 2D image by iteratively removing noise from an initial noisy image based on the scene encoding tensor outputted by the scene encoder. Examples of diffusion models include cascade models or latent diffusion models. Cascade models are models that include several diffusion modules, e.g., one for outputting an image conditioned on the scene encoding tensor, and then super-resolution models to upscale this image to a higher resolution. During inference, the diffusion model may generate the outputted 2D image by iteratively removing noise from an initial noisy image. Each iteration of the removing of the noise may comprise determining a new version of the initial noisy image which is less noisy than a previous version of the initial noisy image determined during the previous iteration. The determining of the new version may be based on a prediction of the noise in the previous version.

The training of the diffusion model is now discussed. The training of the diffusion model may be based on produced noisy versions of the 2D images that the dataset includes. For example, the machine-learning method may comprise producing noisy versions of the 2D images of the dataset (by adding noise to these 2D images), and the training of the diffusion model may be based on the produced noisy versions of the 2D images. The diffusion model may be trained to remove the noise added in the 2D images of the dataset considering the scene encoding tensors outputted by the scene encoder. In that case, the training of the diffusion model and the scene encoder may consider a training loss penalizing a distance between a noise predicted in the generated noisy versions and an actual noise in the produced noisy versions.

In examples, the diffusion model may have an architecture that includes a denoiser. The denoiser may comprise several blocks configured for producing the generated 2D image. At least one of these blocks may be enhanced with cross-attention using the scene encoding tensor. The cross-attention mechanism may be the attention mechanism applied between elements from different sequences. The cross-attention may be applied between the representations returned by the transformer encoder for the different tokens, and visual features computed within the denoiser. It improves the ability of the function to learn the visual and spatial dependencies/relationships that exist between scene features (encoded by the transformer encoder) and their visual representation in the image (produced by the denoiser). This mechanism is therefore particularly well-suited to the generating of 2D images of 3D scenes, for which the position/notion of spatiality of objects in the 2D image is paramount.

In examples, the diffusion model may be configured for operating in a latent space (i.e., may be a latent diffusion model). In that case, during the training, the diffusion model may be trained for denoising compressed latent representations of the 2D images of the dataset. In that case, the training of the function may comprise compressing the 2D images of the dataset in the latent space (e.g., of smaller dimension), thereby obtaining the compressed latent representations. The training may be performed based on these compressed latent representations (instead of the 2D images directly). During inference, the diffusion model may take as input, instead of an initial noisy tensor, a compressed initial noisy tensor of same dimension than the compressed latent representations. The diffusion model may iteratively remove noise from this compressed initial noisy tensor considering the scene encoding tensor outputted by the scene encoder. After that, a decompression may be applied on the result so as to obtain the generated 2D image. Examples of implementation of such compression/decompression include Variational Autoencoders (VAEs).

The applying of the function is now discussed. The applying of the function may comprise initially a step of forming the input of the diffusion model. When the diffusion model does not operate in the latent space, this step may comprise sampling an initial noisy tensor, e.g., having the shape of the 2D image to be generated. This initial noisy tensor may be taken as input by the diffusion model. When the diffusion model operates in the latent space, this step may comprise sampling the compressed initial noisy tensor (i.e., having same dimension than the compressed latent representations). This compressed initial noisy tensor may be taken as input by the diffusion model.

Then, the applying of the function may comprise the applying of the scene encoder to the obtained layout, thereby outputting a scene encoding tensor. After that, the applying of the function may comprise using the diffusion model conditioned on the outputted scene encoding tensor for generating the 2D image of the 3D scene. The diffusion model may iteratively remove noise from the sampled initial noisy tensor when not operating in the latent space or otherwise to its compressed representation. When operating in the latent space, the applying of the function may further comprise a step of decompressing a clean latent (obtained by iteratively applying the denoiser) to get back to the image space and obtain the generated 2D image.

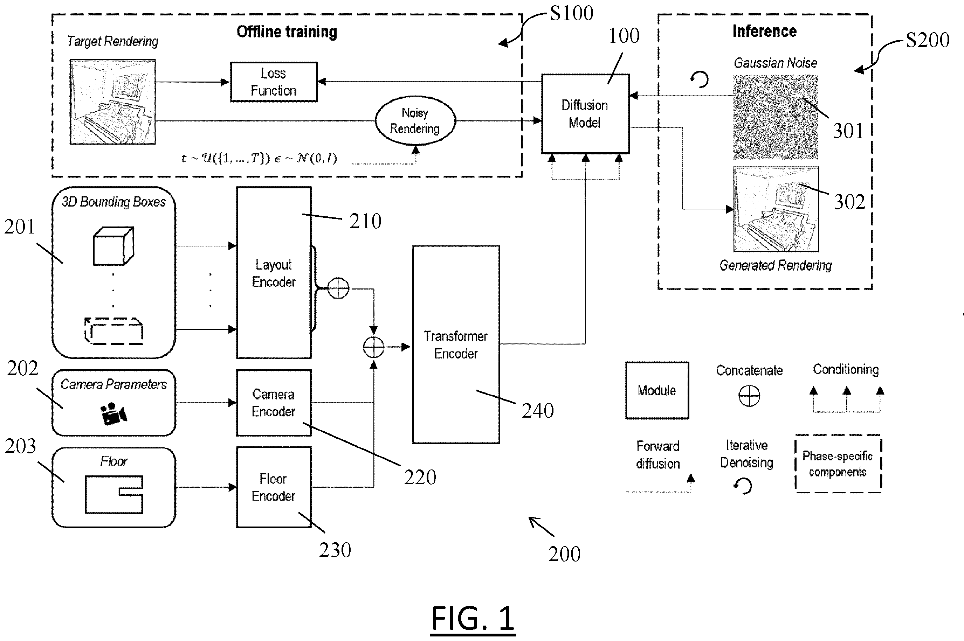

With reference to FIGs. 1 to 14, examples of implementations of the machine-learning method and the using method are not discussed.

The trained function is conditioned on the outputted scene encoding tensor (i.e., is 3D-aware). This allows leveraging knowledge about the 3D structures and relationships of the objects in scenes or environments and therefore producing more accurate, natural-looking and immersive content thanks to an improved consideration for e.g., perspective, occlusion or lightning factors. In particular, the trained function solely comprises a scene encoder and a single conditional diffusion model that are specifically trained end-to-end for this task. It does not leverage large and general-purpose pretrained image synthesis priors, does not comprise several training phases to separately train modules, nor requires to train a neural volume renderer or a NeRF for each generated scene. 3D-awareness is incorporated thanks to the layout of the training samples, so it does not rely on separate depth estimators that are usually flawed and propagate errors, nor requires multi-view datasets for training. The using method also enhances user interactions and level of controllability.

The machine-learning method and the using method solve the problem of generating high quality, user-specified 2D views of a 3D environment that is not made up of premade 3D models and textures, but rather of a high-level/abstract description of the said environment, i.e., the annotated 3D bounding boxes representing the elements (or objects) in the scene.

To do so, the function is trained for generating an image of a scene, given as input a camera viewpoint (position and rotation), a set of annotated bounding boxes representing the objects in the scene (position, dimension, orientation, and a tag representing the class of the object) and the corners (i.e., boundaries, shape or floor plan) of the room that the 3D scene represents.

The machine-learning method and the using method solve this technical problem using a Deep Learning based approach. Its pipeline may be divided into two main stages.

In a first stage (offline stage), the machine-learning method performs a supervised training of the function. Given a dataset of pairs of a 2D image and the corresponding underlying scene annotation (camera viewpoint and field of view, annotated bounding boxes of the objects, visible or not, present in the scene and floor corners), the machine-learning method comprise the training of a function including a Deep Learning pipeline that is composed of:

- a scene encoder (hereinafter also referred to as scene layout encoder) that comprises:

  ○ a layout encoder that outputs a vector embedding for each of the objects present in the scene.
  ○ a camera encoder that outputs a vector embedding capturing the information about the camera.
  ○ a floor encoder that outputs a vector embedding capturing information about the shape of the floor.
  ○ a transformer encoder which takes as input the sequence resulting from the concatenation of the previously described embeddings and outputs a sequence of new representations / embeddings.

- a diffusion model (hereinafter also referred to as denoising diffusion model) which takes as input a noisy version of the provided 2D image as well as the scene embedding outputted by the scene encoder for conditioning. The denoising diffusion model may either operate directly in the image space, or in a latent space, in which case the denoising diffusion model may contain a Variational Autoencoder (VAE).

The goal of the supervised training phase is to give the function the ability to reproduce (or generate) a 2D reference image given as input the corresponding scene annotations (i.e., layout) of a 3D scene.

In a second stage (inference stage or online stage), the trained function may be used for generating 2D image. On the one hand, a scene embedding tensor is computed using the layout encoder, the camera encoder, the floor encoder and the transformer encoder by taking as input a user-defined scene annotation. On the other hand, a random Gaussian noise image is sampled (either in the image space or in the latent, space depending on the nature of the diffusion model). The scene embedding and the image being denoised are iteratively fed to the trained denoising diffusion model, which outputs a 2D image corresponding to the desired scene at the desired viewpoint.

Key advantages of the machine-learning method and the using method include:

- Time efficiency: once trained, the function (or model) is able to create high quality 2D images quicker than existing rendering solutions from traditional computer graphics: no expensive raytracing or post-processing effects are used for the generation. Generating a 2D view takes no more than a couple of seconds on a GPU, and less than a minute on a CPU.

- Creativity and user-driven:

  ◦ The trained function is able to output scenes containing objects that were not present in the original dataset, without the need for creating new 3D models and textures.
  ◦ The trained function enables a new creation workflow by letting the user easily and quickly provide an abstract 3D layout without specifying and manually selecting the exact 3D items to be represented which is usually both tedious and time-consuming.

- Space efficiency:

  ◦ Once the deep learning model is trained, it weighs about a few gigabytes on disk yet is able to produce infinitely many object variations. Comparatively, storing thousands of 3D meshes and their textures is not as space efficient.
  ◦ Since it can be specialized on relatively small datasets, the 3D-aware diffusion model can be smaller (i.e., has less training parameters) than the ones employed in other methods.

- Image fidelity: the trained function can output images in which the effects of unseen objects are accounted for (e.g., for an interior scene, a window that is out of the camera frustum will still affect the output image by influencing the lighting).

Definitions of certain terms are now presented.

Deep Neural Networks (DNNs) are a powerful set of techniques for learning in Neural Networks which is a biologically inspired programming paradigm enabling a computer to learn from observational data. In object recognition, the success of DNNs is attributed to their ability to learn rich midlevel media representations as opposed to hand-designed low-level features (Zernike moments, HOG, Bag-of-Words, SIFT, etc.) used in other methods (min-cut, SVM, Boosting, Random Forest, etc.). More specifically, DNNs are focused on end-to-end learning based on raw data. In other words, they move away from feature engineering to a maximal extent possible, by accomplishing an end-to-end optimization starting with raw features and ending in labels.

Generative image models are a type of deep neural networks, which are trained on large image datasets to learn the underlying distribution of the training images. By sampling from the learned distribution, such models can produce new images that possess characteristics from the ones in the training dataset. GANs (Generative Adversarial Networks), VAEs (Variational Autoencoders), and Diffusion Models are widely recognized as the most popular generative image models, with Diffusion Models currently regarded as the state-of-the-art approach in the field.

Diffusion models are a type of deep learning models that can be used for image generation. They aim to learn the structure of a dataset by modeling how data points diffuse through the latent space. Diffusion models consist of three components: the forward process, the reverse process and the sampling phase. In the forward process, Gaussian noise is added to the training data through a Markov chain. The goal of training a diffusion model is to teach it how to undo the addition of noise, step by step. This is done in the revere process, where the diffusion model reverses the noise addition performed in the forward process, and therefore recovers data. During the sampling phase, an image generation diffusion model starts with a random Gaussian noise image. After being trained to reverse the diffusion process on images from the training dataset, the model can generate new images that resemble the ones in the dataset. It achieves this by reversing the diffusion process, starting from the pure Gaussian noise, up until a clear image is obtained.

An autoencoder is a neural network architecture used for dimensionality reduction and data compression. It consists of an encoder that maps input data to a lower-dimensional representation, and a decoder that reconstructs the original data from an encoded representation. By compression and reconstructing data, autoencoders extract meaningful features and enable tasks such as data compression. A variational autoencoder (VAE) is a special type of autoencoder that incorporates probabilistic modeling. Instead of learning a deterministic mapping, VAEs learn the parameters of a probability distribution over the latent space.

Transformers are a type of deep neural networks architecture, which possess remarkable ability to perceive relationships among elements within an input sequence. Thanks to a mechanism called self-attention, Transformers make it possible for the model to learn the relevance of each element to the others, and to weigh the contextual information appropriately. Transformer modules take as input a sequence and output a new vector representation of the input data, in which relations within the input sequence are emphasized.

Cross-attention expands on the self-attention mechanism by allowing for correlations or contextual information to be picked between different sequences. The input used for cross-attention are two different sequences of same or different modalities (e.g., text or image). The model learns to attend to the relevant information from one of the sequences into the other one. Cross-attention is appropriate when dealing with tasks that involve incorporating information from other sources to enhance a model's capabilities.

In the context of generative AI models for image synthesis, conditioning refers to the process of injecting additional information into the image generation process in order to get results which match user-driven constraints. Conditioning can come in various forms, including text (e.g., DALL-E 2, Midjourney or Stable Diffusion) or image (e.g., Control Net or semantic segmentation) for example.

The (3D) bounding box of a three-dimensional (3D) object is the smallest rectangular cuboid that encloses the object. Its position, its dimension and its orientation characterize a 3D bounding box. Two opposite vertices are enough to fully describe a 3D bounding box.

The "viewpoint" represents the perspective or "camera" from which the render is captured. It may comprise four components: a position, an orientation, and a field of view and a pitch. The position and orientation of the viewpoint and those of the bounding boxes may be defined within a single frame of reference.

The term "3D abstracted scene" represents a list of labeled bounding boxes (the layout of the 3D scene) representing objects in a scene (the labels correspond to the class of the object), a viewpoint, and optionally other elements which may enrich the description of the environment (information about the shape of a room for instance). The adjective "abstracted" highlights that objects in the scene have no visual representation and are not defined beyond the characteristics of their bounding boxes and their label.

One-hot encoding is a technique to represent categorical variables as binary vectors. It consists in creating a binary vector for each category where only one coordinate is set to one and the rest are set to zero. This representation allows categorical data to be converted into a numerical format which can be processed by a deep neural network.

A scene encoder refers to a specialized deep neural network that learns to extract comprehensive representations from a 3D scene, which may contain spatially positioned objects, a layout, or a viewpoint. The scene encoder takes in diverse inputs, depending on its specific architecture and the user's needs and generates a high-dimensional vector output. This encoded representation should capture the important features of the scene and serves as valuable input for subsequent stages in the deep learning model.

FIG. 1 illustrates a flowchart of an example of the machine-learning method and of the using method.

The pipeline is composed of a diffusion model 100 that is conditioned by a novel 3D scene encoder 200. Like other deep learning models, it features an offline stage S100 (training of the function by executing the machine-learning method) and an online stage S200 (generation of 2D images by executing the using method, also called inference stage).

The offline training stage S100 is now discussed in more details. The objective of this stage is to simultaneously (i) train the scene encoder 200 to produce a comprehensive mathematical representation that can be used for conditioning and (ii) train the diffusion model 100 to generate images from noise. The scene encoder 200 takes as input a set of elements which characterize the 3D scene (the layout of the 3D scene) and outputs a scene encoding tensor. The diffusion model 100 takes as input a noisy version of the image to be generated as well as a scene encoding tensor, and outputs a denoised version of the input image. This training is end-to-end: a single loss value is computed and backpropagated to adjust the weights of both the diffusion model and of the scene encoder. Setting up the training stage may comprise the following sub-tasks:

- Data preprocessing step: data samples of the dataset, especially the scene annotation (i.e., the layouts), might be processed so they can be passed to the scene encoder.
- Definition of the architecture step: the scene encoder 200 may return a single fixed-size tensor embedding for the whole scene being rendered. The diffusion model 100 may take as input a noisy version of an image as well as a scene encoding vector. It may return an estimation of the noise added to the image and use it to propose a less noisy version of the input image.
- Definition of the training loss step: the training loss function may measure the distance between the predicted noise in the input image and the true noise in the image added through the forward process.
- Training step: the training may be performed by iterating several times over the dataset (pairs of images and scene annotations).

The image generation/inference stage S200 is now discussed in more details. This stage aims at, given an abstract 3D scene, output a rendering which matches its viewpoint. For this stage, the using method may comprise the following sub-tasks:

- Determining of the scene embedding vector step: using the scene encoder 200 and the input abstracted 3D scene, computing a scene embedding vector. The abstracted 3D scene does not necessarily have to be part of the database (e.g., it can be user-created or generated using other techniques).

- Generating a random Gaussian noise image step: the Gaussian noise image 301 may have the size of the desired final image when training in the pixel space, or of the size of the VAE's latent space when training a Latent Diffusion Model.
- Iteratively denoise the generated image step: using the diffusion model 100, first denoising the random Gaussian noise image 301 and iteratively denoising the output of the diffusion model. The U-Net denoiser (DNN backbone of the diffusion model) may be conditioned on the scene embedding vector using cross-attention between the layers of the U-Net and the scene embedding vector. After a fixed number of denoising steps, the final clear image 302 is generated.

An example of implementation of the previously described general framework is now discussed. This example focuses on the generation of interior scenes.

Details about the acquisition and the content of the dataset used for training the function are now presented. The data used may be extracted from HomeByMe renderings taken by users (i.e., 2D images created by real users). HomeByMe is a free interior design app, that allows users model their home in 3D, by selecting and placing furniture among an extensive object catalog and generate photorealistic 2D renderings of their room. Whenever a high-quality rendering is taken in the application, a rich annotation file is saved jointly with the image. The raw data from this annotation file contains information about the rendering (semantic segmentation map and/or 2D bounding boxes of the visible objects) as well as information about the 3D scene the rendering was taken in (3D bounding boxes of the objects, room's shape and/or viewpoint). Out of this raw data, three elements may be extracted:

- 3D bounding boxes: for each object in the scene (not necessarily visible from the render taken by the user), the annotation file contains a list of miscellaneous features describing the object, and in particular the following attributes: the class of the object and its 3D bounding box. The raw data retrieved from this file defines 3D bounding boxes by two 3D points corresponding to two opposite vertices of the bounding box. There is a total of 174 possible classes in the HomeByMe dataset.
- Viewpoint: the viewpoint from which the user's rendering was taken may be saved in the annotation file. In particular, the position of the camera, its orientation and its field of view are retrieved and later used in the pipeline.
- Room's shape: the room's shape is stored in the annotation file as a list of 2D points representing the corners of the room.

An example of function has been trained on approximatively 60.000 (3D annotation, HQ rendering) pairs of bedroom projects. It may however be scaled to much larger datasets featuring other types of rooms.

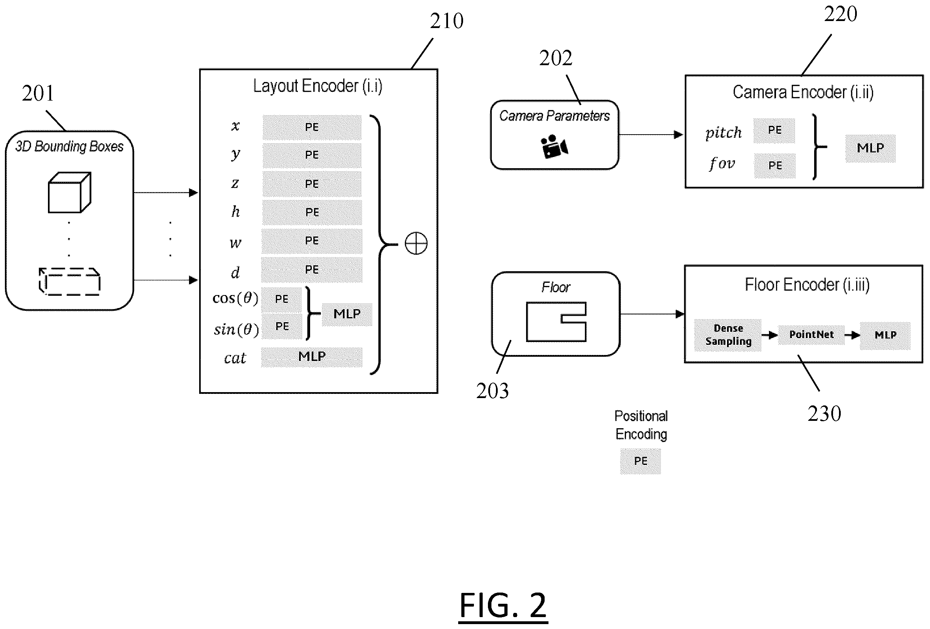

FIG. 2 illustrates an example of the scene encoder 200 of FIG. 1. The scene encoder 200 includes a layout encoder 210 configured for encoding the set of bounding boxes 201. The layout encoder 210 takes as input, for each bounding box of the set 201, parameters representing a position, a size and an orientation in the 3D scene of the object represented by the bounding box, and optionally a class of the object represented by the bounding box. The scene encoder 200 further includes a floor encoder 230 configured for encoding the boundaries 203 of the 3D scene. The scene encoder 200 further includes a camera encoder 220 configured for encoding the viewpoint 202. As illustrated in FIG. 1, the scene encoder 200 further includes a transformer encoder 240. The transformer encoder takes as input a concatenation of the set of bounding boxes 201 encoded by the layout encoder 210, the viewpoint 202 encoded by the camera encoder 220 and the boundaries of the 3D scene 203 encoded by the floor encoder 230. The transformer encoder 240 outputs the scene encoding tensor.

The offline training stage S100 is now discussed in more details.

The machine-learning may comprise, prior to the training step, a data processing step for processing the layout and viewpoint of each 2D image of the dataset.

The data processing step may comprise a first step for processing, in each 3D scene, the 3D bounding boxes. The first step may comprise converting the raw 3D bounding boxes from a representation based on two opposite vertices to a representation by their position (x, y, z), their dimension (width w, height h, depth d) and their orientation. There may be only one rotational degree of freedom for the objects present in the scene: their rotation around the vertical axis. As a consequence, the machine-learning method may use only a single angle $\theta$ to define the orientation of the bounding boxes. In practice, the machine-learning method may use a different representation and encode the orientation of the 3D bounding box by a pair corresponding to $(\cos(\theta), \sin(\theta))$. Such a parametrization is mathematically equivalent to the single value parametrization, but it forces the continuity of the deep learning model for $\theta = 0$ and $\theta = 2\pi$. This is benefit for the convergence of the model. Thus, the processed 3D bounding boxes are defined by a list of 8 parameters (x, y, z, w, h, d, $\cos(\theta)$, $\sin(\theta)$).

The data processing step may comprise a second step for processing object's class. Each object from the HomeByMe dataset may be described by a class which provides a broad description (chair, table or door). There may be a total of 174 classes in the HomeByMe dataset. To be fed to the deep learning model, the class of the object is converted to a one-hot encoded representation in $\{0,1\}^{174}$. This step may be done otherwise (e.g., using a vector representation/embedding of the textual class of the object using common techniques such as word2vec, etc., as described in the paper by Mikolov, T., Chen, K., Corrado, G., & Dean, J., 2013, "Efficient estimation of word representations in vector space", arXiv preprint arXiv:1301.3781).

The data processing step may comprise a third step for processing the boundaries of the layout. The third step may comprise increasing dimensionality of the floor points. The raw points from the data annotations are 2D points (x, y) because their Z coordinate is implicitly 0. The 2D points are turned into 3D points by using 0 as the Z coordinate. This step is necessary so that the 3D points are affected by the transformations described later.

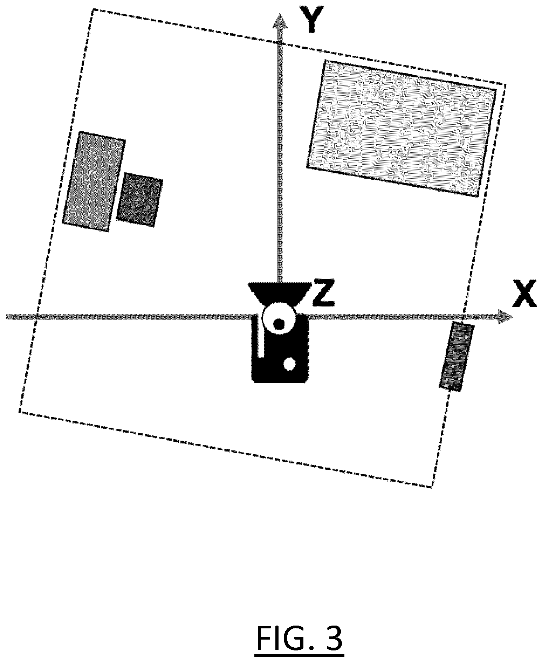

The data processing step may comprise a fourth step for processing coordinates of the bounding boxes, notably from world coordinates to camera coordinates (illustrated in FIG. 3). The raw positions and orientations found in the annotation file are using world coordinates defined in HomeByMe. To reduce the number of learned parameters, encourage robustness and thus facilitate convergence, the data processing step may perform a change of basis, which goes from the original world coordinates to a coordinate system that is based on the viewpoint. In the new coordinate system, the origin of the world is set to the camera position and the basis vector are selected so that: the "Z" basis vector is unchanged, the "Y" basis vector is the projection of the viewpoint's forward vector on the plane orthogonal to the "Z" vector, and the "X" vector is orthogonal to the first two. Thanks to this change of basis, a viewpoint can be described purely by two scalar values: the field of view (FOV) and the pitch (the angle its forward vector makes with the "Y" basis vector). This change of basis affects the position and rotation of all the objects and points in the scene. Such a change of basis is optional but helps with the convergence of the function.

The architecture of the scene encoder is now discussed in more details.

The scene encoder is composed of four components: the layout encoder, the camera encoder, the floor encoder and the transformer module (or transformer encoder) (see FIG. 2).

The layout encoder is now discussed. The scalar values (x, y, z, w, h, d, cos ($\theta$), sin ($\theta$)) which describe each bounding box in the scene may be passed through a Positional Encoding module (PE) which deterministically increases the dimension of the scalar value. In this example, scalar values are represented with a vector in $\mathbb{R}^{64}$. Positional encoding enables the generation of diverse representations of the same scalar value, allowing deep learning models to capture more nuanced information when necessary. The use of positional encodings is useful to improve the deep neural network convergence.

After the positional encoding modules, the position and dimension of the bounding boxes which are respectively originally described by three scalar values are described by a 192-dimensional vector ($3 \times 64 = 192$). On the other hand, the rotation which is originally described by a pair of scalar values is described by a 128-dimensional vector after the positional encoding. To ensure that the position, dimension and rotation are weighed in similarly by the model, the high dimensional version of the rotation is passed to a multi-layer perceptron which maps it from $\mathbb{R}^{128}$ to $\mathbb{R}^{192}$. This step improves the model's convergence.

The one-hot encoded category is a vector from $\{0,1\}^{174}$. To ensure that the category is weighed in similarly to the position, the dimension and the rotation of the bounding box, the category vector is passed to a multi-layer perceptron which maps it to a lower dimensional representation in $\mathbb{R}^{128}$.

All the previously computed vectors are concatenated in a single vector in $\mathbb{R}^{768}$. This vector is a token representing a labelled 3D bounding box.

The camera encoder is now discussed. The camera or viewpoint is fully described by two scalar values: the field of view and the pitch. Both of these values are sent to a higher dimension ($\mathbb{R}^{64}$) using a positional encoding, and then fed to a multi-layer perceptron which maps them to $\mathbb{R}^{768}$. This vector is a token representing the viewpoint in the scene.

The floor encoder is now discussed. The floor is only represented by an unordered set of 3D points corresponding to its corners. Such a representation is ambiguous and cannot be easily interpreted by the deep neural network. As an alternative, the data processing step may comprise densely sampling points along the walls of the room so that the borders of the room are represented by a 3D point cloud, thereby generating a set of points sampled along the boundaries. This 3D point cloud is then fed to a PointNet module which outputs an embedding vector in $\mathbb{R}^{1024}$. This embedding is itself fed to a multi-layer perceptron which maps the vector to $\mathbb{R}^{768}$. This final vector is a token representing a floor point. The floor encoder improves the quality of the generated images.

The transformer module is now discussed. The 3D bounding boxes tokens, the camera token and the floor token are all concatenated to form a sequence of tokens. These tokens are independent from one another. In order to capture relationships between the different elements of this sequence, a transformer module is used. The transformer module operation may be improved with a fixed input size because of its intrinsic architecture. However, the sequence built through the concatenation of the outputs of the layout encoder, the camera encoder and the floor encoder may have a variable length as the number of 3D bounding boxes in a scene may vary from scene to scene. To be compatible with the transformer architecture, the concatenation of the vectors sequence may be padded with "zero" tokens ( $0_{\mathbb{R}^{768}}$ ) so that the sequence is of fixed length. In coherence with the distribution of number of 3D bounding boxes in the dataset, the data processing step may pad the concatenation of the vectors to be 50 tokens long. The sequence may thus be represented as a tensor from $\mathcal{M}_{768\times50}(\mathbb{R})$ . This tensor may be fed to the transformer module, which may output the final scene embedding vectors.

The architecture of the diffusion model is now discussed. The function may comprise one of two versions of the diffusion model: one which acts directly in the image space and the other one which acts in the latent space of a pretrained VAE for increased final image dimension. In the first case, the diffusion occurs directly on the pixels from the image while in the second case, the diffusion occurs on a latent version of the image, which is then decoded using the VAE decoder. The two approaches are not fundamentally different and do not require much change other than the introduction of the VAE.

The diffusion model has an architecture for conditional generation, featuring a U-Net backbone comprising four down blocks and four up blocks. Notably, the last two down blocks and the initial two up blocks may be enhanced with cross-attention, utilizing the scene embedding vectors. The number of up/down blocks and the number of blocks enhanced with cross-attention can vary depending on the needs and the means of the user. This configuration offers the best compromise between image quality and training time.

The training loss used for the training is now discussed. The diffusion model may be trained using different losses/parameterizations. The noise added to the input image during the forward process is known as it is deterministically added. During the training, the diffusion model tries to predict the noise which was added to the image. The loss used in that case is the mean squared error between the true noise $\varepsilon$ and the predicted noise $\varepsilon_\theta$ ($\theta$ indicates that the prediction is done based on the model's parameters).

$$MSE = \frac{1}{\#channels \times \#pixels} \sum_{\forall channels\, \forall pixels} (\epsilon - \epsilon_\theta)^2$$

Alternatively, other commonly used diffusion training parameterizations/ losses may be interchangeably employed. For example, a v-prediction parameterization with min-SNR Weighting value of 5.0 leads to a good image quality/resolution/computation trade-off (e.g., as discussed in the paper by Tiankai Hang et al., "Efficient Diffusion Training via Min-SNR Weighting Strategy", in ICCV 2023).

The generation/inference stage S200 is now discussed in more details. The diffusion model may be configured with different techniques at inference. For example, two different sampling processes may be used: Denoising Diffusion Probabilistic Models (DDPM) and Denoising Diffusion Implicit Models (DDIM). DDIM may for example offers the best balance between inference speed and image quality. When inferring the image for a given 3D abstract scene, the generation may take about 1 second on a NVIDIA RTX A6000 GPU.

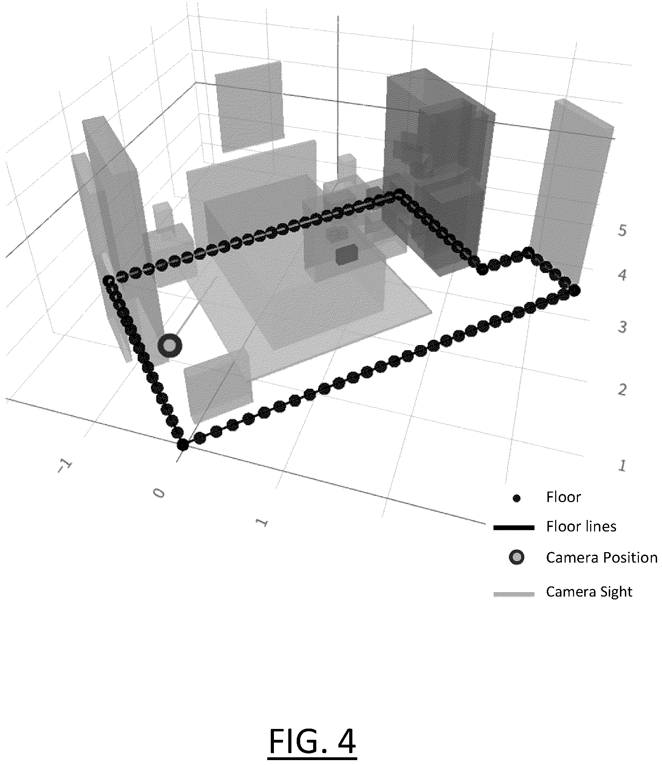

Examples of results are now discussed in reference to FIGs. 4 to 12.

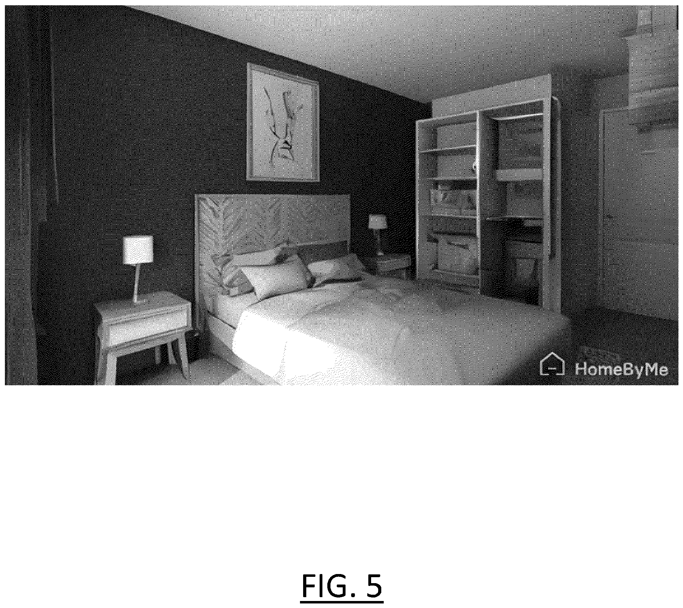

FIG. 4 shows a first example of layout and viewpoint of a 3D scene. The figure shows the bounding boxes encapsulating the objects of the room that the 3D scene represents. Object's bounding boxes may be colored according to their category. These layout and viewpoint are taken as input by the trained function, which generates the 2D image illustrated in FIG. 5. In the generated 2D image, conditioning elements are well represented. Off-screen objects also have an impact on the generated content (e.g., the lightning effect on the bed just in front of the room's window). The 3D bedroom layouts used for qualitative results and quantitative evaluations have been drawn from an independent set that has not been used in the training distribution. This helps ensuring the robustness and generalization capabilities of the model.

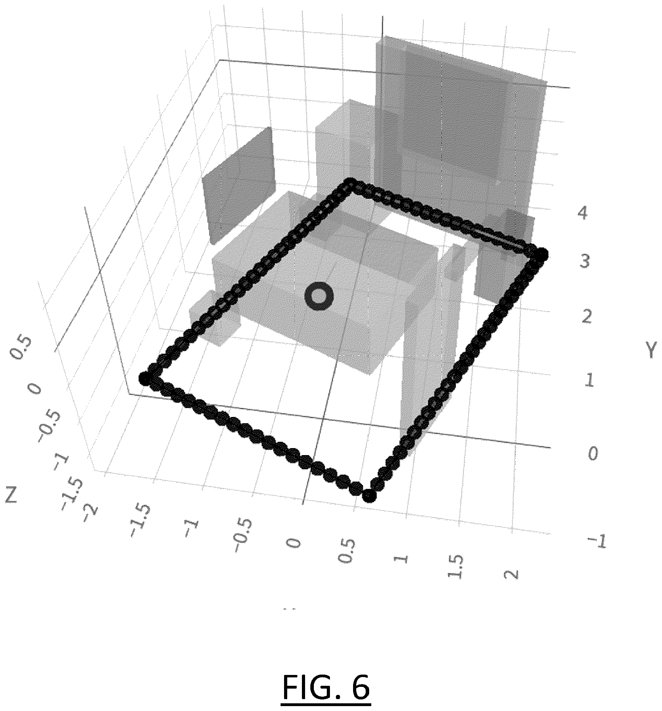

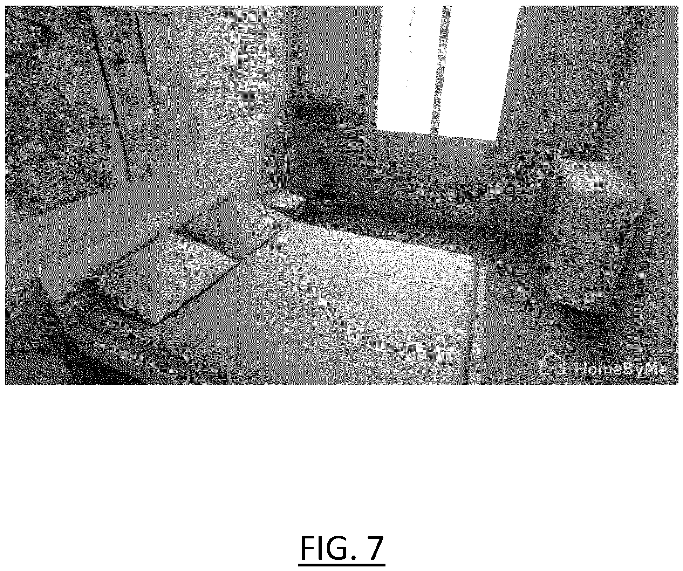

Similarly, FIG. 6 shows a second example of layout and viewpoint of a 3D scene, and FIG. 7 the resulting 2D image generated by the trained function.

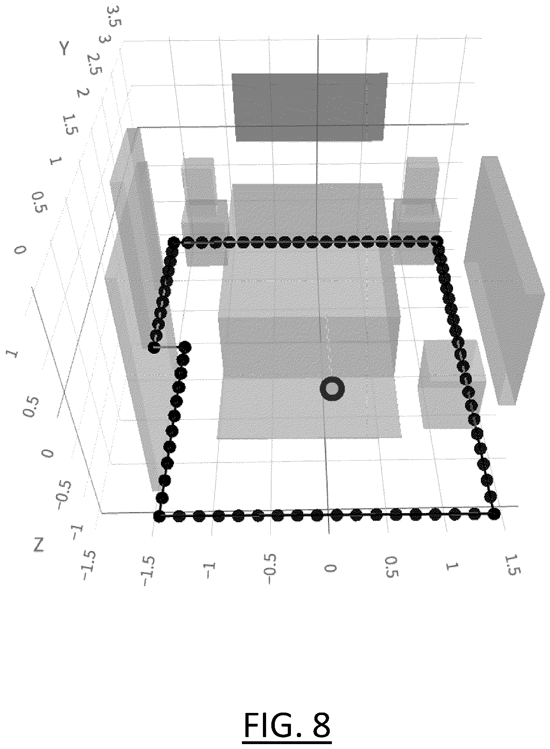

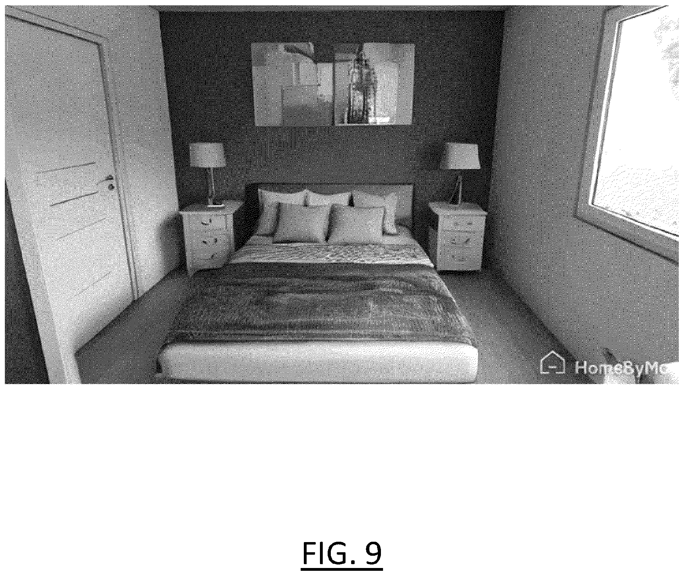

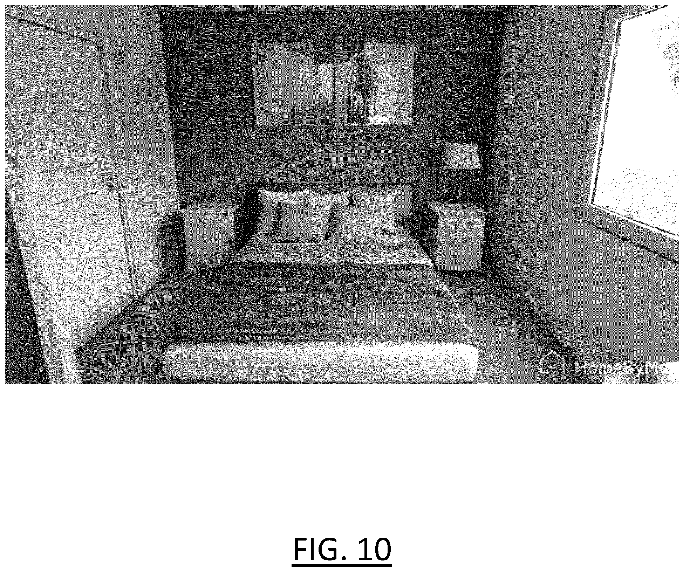

FIG. 8 shows a third example of layout and viewpoint of a 3D scene, and FIG. 9 the resulting 2D image generated by the trained function. After that the user manipulates the input 3D layout, e.g., by removing the lamp on the left nightstand, the function may generate another image again shown in FIG. 10.

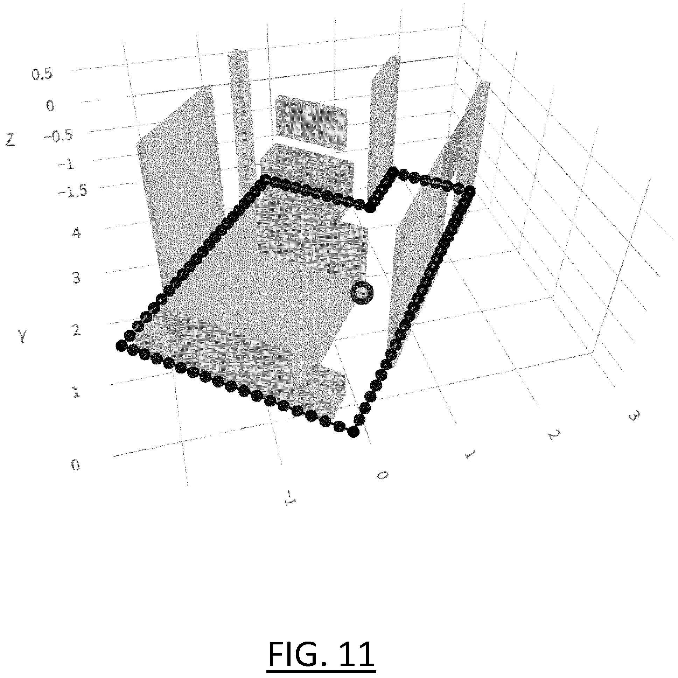

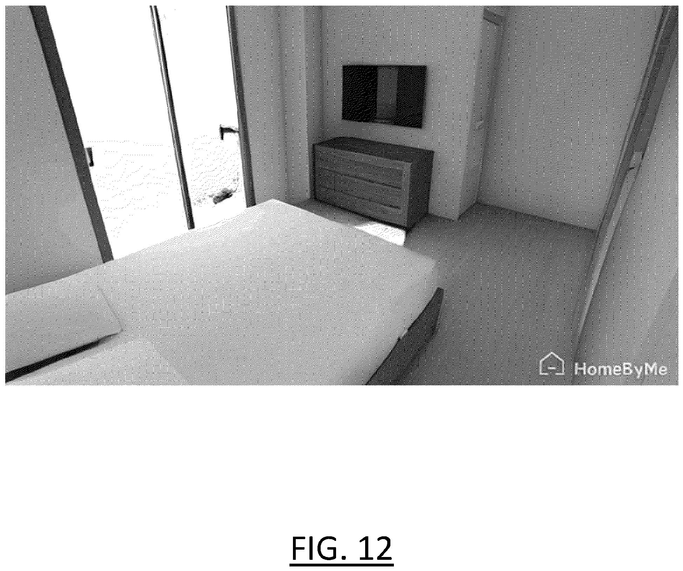

FIG. 11 shows a fourth example of layout and viewpoint of a 3D scene, and FIG. 12 the resulting 2D image generated by the trained function.

The trained function takes on the double challenge of generating 2D images from a 3D scene. First, the diffusion model adheres to its 3D conditioning to ensure objects appear in their expected locations. In other words, when given a viewpoint and a set of objects in 3D space, the model outputs objects in similar positions as a traditional 3D renderer would. Secondly, in addition to accurately placing objects, the trained function generates objects that are recognizable or correct. Consequently, the trained function enables high local image fidelity, and therefore high quality of the output image.

Results of the quantitative evaluation performed to evaluate the trained function are now presented. 2D images generated by the trained function are evaluated using a metric that assesses both 3D conditioning and local image quality. The aim of this metric is to determine if objects are correctly placed in the 2D image and recognizable. It requires a ground-truth image and a generated image corresponding to the same viewpoint. It leverages the CLIP model (as discussed in the paper by Radford, Alec, et al. "Learning transferable visual models from natural language supervision", International conference on machine learning, PMLR, 2021). CLIP (Contrastive Language-Image Pre-Training) is a multimodal foundation model that learns a joint latent space for text and images. It has been trained on hundreds of millions of (text, image) pairs and is therefore able to connect complex visual concepts with their description in natural language. The embedding computed by CLIP's text encoder from a text prompt will have a high cosine similarity with the one computed by its image encoder from an image that is semantically close to the prompt. CLIP has been widely adopted in recent research works in computer vision for its strong zero-shot capabilities, allowing to perform several tasks such as image classification or open-vocabulary semantic segmentation. Its shared latent space allows to interchangeably use text and image modalities. The metric is computed by performing, for each object in the ground-truth image, the following steps:

1. Crop the region corresponding to the object.
2. Compute the CLIP embedding of the crop.
3. Use CLIP as a zero-shot classifier for top-k retrieval to check if the true category of the cropped object is among the top categories in the retrieval. The classifier keys are computed using the CLIP embedding of the parsed text object categories. The cosine similarity is used as the value to compare the crop CLIP and the categories CLIP.
4. If the crop in the ground-truth image is recognized, crop the generated image in the same region.
5. Compute the CLIP embedding of the generated crop.
6. Use CLIP as a zero-shot classifier for top-k retrieval to check if the category of the generated object is correct.
7. The accuracy value is the ratio of correctly identified generated crops to correctly identified ground-truth crops.

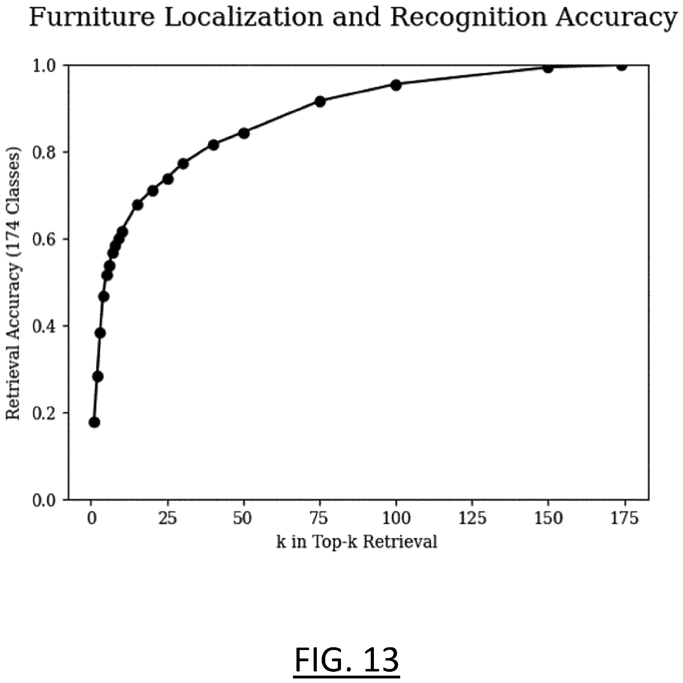

The results obtained with this metric on an evaluation set of about 100 scenes are shown in FIG. 13. The quantitative evaluation of the function reveals that in a top-10 retrieval scenario (out of 174 classes), 60 % of the objects are identified correctly. This accuracy increases to more than 75% in a top-25 retrieval. These results demonstrate that the diffusion model of the trained function generates objects that are not only accurately placed but also realistic enough to be recognized by a CLIP zero-shot classifier in most cases.

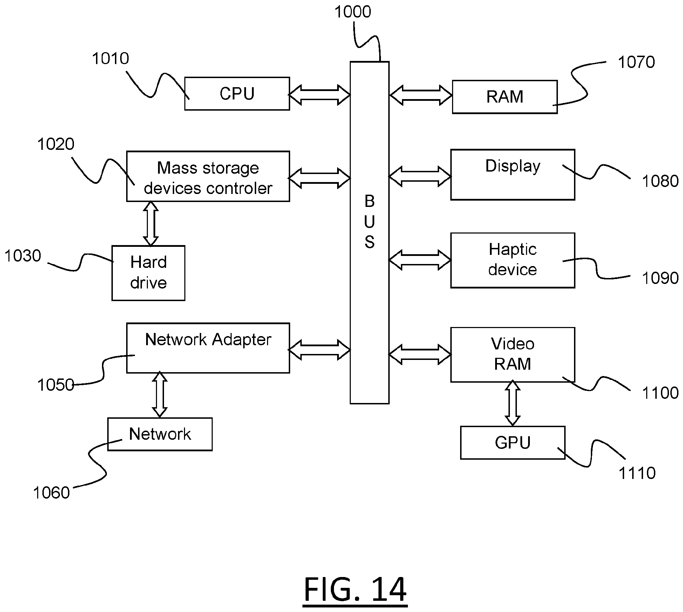

FIG. 14 shows an example of the system, wherein the system is a client computer system, e.g. a workstation of a user.

The client computer of the example comprises a central processing unit (CPU) 1010 connected to an internal communication BUS 1000, a random-access memory (RAM) 1070 also connected to the BUS. The client computer is further provided with a graphical processing unit (GPU) 1110 which is associated with a video random access memory 1100 connected to the BUS. Video RAM 1100 is also known in the art as frame buffer. A mass storage device controller 1020 manages accesses to a mass memory device, such as hard drive 1030. Mass memory devices suitable for tangibly embodying computer program instructions and data include all forms of nonvolatile memory, including by way of example semiconductor memory devices, such as EPROM, EEPROM, and flash memory devices; magnetic disks such as internal hard disks and removable disks; magneto-optical disks. Any of the foregoing may be supplemented by, or incorporated in, specially designed ASICs (application-specific integrated circuits). A network adapter 1050 manages accesses to a network 1060. The client computer may also include a haptic device 1090 such as cursor control device, a keyboard or the like. A cursor control device is used in the client computer to permit the user to selectively position a cursor at any desired location on display 1080. In addition, the cursor control device allows the user to select various commands, and input control signals. The cursor control device includes a number of signal generation devices for input control signals to system. Typically, a cursor control device may be a mouse, the button of the mouse being used to generate the signals. Alternatively or additionally, the client computer system may comprise a sensitive pad, and/or a sensitive screen.

The computer program may comprise instructions executable by a computer, the instructions comprising means for causing the above system to perform the method. The program may be recordable on any data storage medium, including the memory of the system. The program may for example be implemented in digital electronic circuitry, or in computer hardware, firmware, software, or in combinations of them. The program may be implemented as an apparatus, for example a product tangibly embodied in a machine-readable storage device for execution by a programmable processor. Method steps may be performed by a programmable processor executing a program of instructions to perform functions of the method by operating on input data and generating output. The processor may thus be programmable and coupled to receive data and instructions from, and to transmit data and instructions to, a data storage system, at least one input device, and at least one output device. The application program may be implemented in a high-level procedural or object-oriented programming language, or in assembly or machine language if desired. In any case, the language may be a compiled or interpreted language. The program may be a full installation program or an update program. Application of the program on the system results in any case in instructions for performing the method. The computer program may alternatively be stored and executed on a server of a cloud computing environment, the server being in communication across a network with one or more clients. In such a case a processing unit executes the instructions comprised by the program, thereby causing the method to be performed on the cloud computing environment.

**Claims**

1. A computer-implemented method for machine-learning a function configured for generating a 2D image of a 3D scene, the function comprising a scene encoder and a generative image model, the scene encoder taking as input a layout of the 3D scene and a viewpoint, and outputting a scene encoding tensor, the generative image model taking as input the scene encoding tensor outputted by the scene encoder and outputting the generated 2D image, the machine-learning method comprising:

   - obtaining a dataset comprising 2D images and corresponding layouts and viewpoints of 3D scenes; and
   - training the function based on the obtained dataset.

2. The machine-learning method of claim 1, wherein the layout of each 3D scene includes:

   - a set of bounding boxes representing objects in the 3D scene; and
   - boundaries of the 3D scene.

3. The machine-learning method of claim 2, wherein the scene encoder includes a layout encoder configured for encoding the set of bounding boxes, the layout encoder taking as input, for each bounding box of the set, parameters representing a position, a size and an orientation in the 3D scene of the object represented by the bounding box, and optionally a class of the object represented by the bounding box.

4. The machine-learning method of claim 3, wherein the scene encoder further includes a floor encoder configured for encoding the boundaries of the 3D scene.

5. The machine-learning method of claim 4, wherein the scene encoder further includes a camera encoder configured for encoding the viewpoint.

6. The machine-learning method of claim 5, wherein, for each given 2D image of a given 3D scene in the dataset, the size and the position of the object represented by the bounding boxes in the layout of the given 3D scene are defined in a coordinate system that is based on a position and an orientation of a camera from which the given 2D image is taken, each viewpoint comprising a field of view and a pitch of the camera.

7. The machine-learning method of claim 5 or 6, wherein the scene encoder further includes a transformer encoder, the transformer encoder taking as input a concatenation of the set of bounding boxes encoded by the layout encoder, the viewpoint encoded by the camera encoder and the boundaries of the 3D scene encoded by the floor encoder, the transformer encoder outputting the scene encoding tensor.

8. The machine-learning method of any of claims 1 to 7, wherein the generative image model is a diffusion model.

9. The machine-learning method of claim 8, wherein the diffusion model has an architecture including a denoiser comprising blocks, at least one of the blocks being enhanced with cross-attention using the scene encoding tensor.

10. The method of claim 8 or 9, wherein the diffusion model is configured for operating in a latent space, the diffusion model being trained for denoising compressed latent representations of the 2D images of the dataset.

11. A method of use of a function machine-learnt according to the method of any of claims 1 to 10, the using method comprising:

   - obtaining a layout of a 3D scene; and
   - applying the function to the layout of a 3D scene, thereby generating a 2D image of the 3D scene.

**12.** The using method of claim 11, wherein the generative image model is a diffusion model, the applying of the function comprising:

- applying the scene encoder to the obtained layout, thereby outputting a scene encoding tensor; and
- using the diffusion model conditioned on the outputted scene encoding tensor for generating the 2D image of the 3D scene.

**13.** A computer program comprising instructions for performing the machine-learning method of any of claims 1 to 10 and/or the using method of claim 11 or 12.

**14.** A computer readable storage medium having recorded thereon a computer program of claim 13.

**15.** A system comprising a processor coupled to a memory, the memory having recorded thereon the computer program of claim 13.

FIG. 1

**FIG. 2**

FIG. 3

Floor
Floor lines
Camera Position
Camera Sight

FIG. 4

## FIG. 5

# FIG. 6

# FIG. 7

FIG. 8

FIG. 9

# FIG. 10

FIG. 11

FIG. 12

Furniture Localization and Recognition Accuracy

FIG. 13

1000

1010

CPU

1070

RAM

1020

Mass storage
devices controler

B
U
S

Display

1080

1030

Hard
drive

Haptic
device

1090

Network Adapter

1050

Video
RAM

1100

Network

GPU

1060

1110

## FIG. 14

Europäisches
Patentamt

European
Patent Office

Office européen
des brevets

## EUROPEAN SEARCH REPORT

**Application Number**

EP 24 30 5100

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | QIUHONG ANNA WEI ET AL: "LEGO-Net: Learning Regular Rearrangements of Objects in Rooms", ARXIV.ORG, CORNELL UNIVERSITY LIBRARY, 201 OLIN LIBRARY CORNELL UNIVERSITY ITHACA, NY 14853, 23 January 2023 (2023-01-23), XP091419569, * abstract; figure 1 * * Section 3; page 3 - page 5; figures 2, 10 * * page 7, column 1, paragraph 2 * * figure 10 * | 1-15 | INV. G06T15/20 |
| X | DESPOINA PASCHALIDOU ET AL: "ATISS: Autoregressive Transformers for Indoor Scene Synthesis", ARXIV.ORG, CORNELL UNIVERSITY LIBRARY, 201 OLIN LIBRARY CORNELL UNIVERSITY ITHACA, NY 14853, 7 October 2021 (2021-10-07), XP091073519, * abstract * * Section 3; page 3 - page 6; figures 2-4 * * section 4.1; page 7 - page 8; figure 4 * | 1-15 | |
| A | HUAN FU ET AL: "3D-FRONT: 3D Furnished Rooms with layOuts and semaNTics", ARXIV.ORG, CORNELL UNIVERSITY LIBRARY, 201 OLIN LIBRARY CORNELL UNIVERSITY ITHACA, NY 14853, 14 May 2021 (2021-05-14), XP081951716, * abstract; figures 1, 3 * | 1-15 | |

**TECHNICAL FIELDS SEARCHED (IPC)**

G06T

-/--

The present search report has been drawn up for all claims

| Place of search | Date of completion of the search | Examiner |
|---|---|---|
| The Hague | 21 May 2024 | Martos Riaño, Demian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

**EUROPEAN SEARCH REPORT**

Application Number

EP 24 30 5100

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | ERIC R CHAN ET AL: "Generative Novel View Synthesis with 3D-Aware Diffusion Models", ARXIV.ORG, CORNELL UNIVERSITY LIBRARY, 201 OLIN LIBRARY CORNELL UNIVERSITY ITHACA, NY 14853, 5 April 2023 (2023-04-05), XP091478116, * abstract * * Section 3; page 3 - page 5; figure 3 * | 1-15 | |
| A | AKSHAY GADI PATIL ET AL: "Advances in Data-Driven Analysis and Synthesis of 3D Indoor Scenes", ARXIV.ORG, CORNELL UNIVERSITY LIBRARY, 201 OLIN LIBRARY CORNELL UNIVERSITY ITHACA, NY 14853, 6 April 2023 (2023-04-06), XP091478303, * abstract * | 1-15 | |

**TECHNICAL FIELDS SEARCHED (IPC)**

The present search report has been drawn up for all claims

| Place of search | Date of completion of the search | Examiner |
|---|---|---|
| The Hague | 21 May 2024 | Martos Riaño, Demian |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **RADFORD et al.** Learning transferable visual models from natural language supervision. *International conference on machine learning, PMLR*, 2021
- **CHARLES R. QI ; HAO SU ; KAICHUN MO ; LEONIDAS J. GUIBAS**. Pointnet: Deep learning on point sets for 3d classification and segmentation. *CVPR*, 2017
- **MIKOLOV, T ; CHEN, K ; CORRADO, G. ; DEAN, J.** Efficient estimation of word representations in vector space. *arXiv preprint arXiv:1301.3781*, 2013
- **TIANKAI HANG et al.** Efficient Diffusion Training via Min-SNR Weighting Strategy. *ICCV*, 2023
- **RADFORD, ALEC et al.** Learning transferable visual models from natural language supervision. *International conference on machine learning, PMLR*, 2021